# EUROPÄISCHE PATENTANMELDUNG

(11) **EP 3 561 750 A1**
(43) Veröffentlichungstag der Anmeldung: **30.10.2019**
(21) Anmeldenummer: 19168860.5
(22) Anmeldetag: 12.04.2019
(51) Int. Cl.: G06Q 10/08, G06Q 30/06, G06F 17/50

(54) **COMPUTERIMPLEMENTIERTES VERFAHREN ZUR DATENBANKGESTÜTZTEN KONFIGURATION UND VISUALISIERUNG EINER FAHRWERKSANORDNUNG**

(30) Priorität: 27.04.2018 DE 102018110231
(71) Anmelder: BPW Bergische Achsen KG, 51674 Wiehl (DE)
(72) Erfinder: Nötzke, Dirk, 51674 Wiehl (DE); Jürges, Nadine, 51588 Nümbrecht (DE); Meyn, Hendrik, 51789 Lindlar (DE)
(74) Vertreter: Bungartz Christophersen Partnerschaft mbB Patentanwälte

(57) **Zusammenfassung**

Die Erfindung betrifft ein computerimplementiertes Verfahren zur datenbankgestützten Konfiguration und Visualisierung einer Fahrwerksanordnung (9) mit mindestens einem aus mehreren Modulen (7) aufgebauten Achsaggregat (8a, 8b), wobei auf einer von einem Anbieter für einen Kunden freigeschalteten Nutzeroberfläche (1) ein Konfigurationsfenster (2) und ein Visualisierungsfenster (3) dargestellt werden, und wobei der Kunde über einen Computer (5) auf eine Datenbank (6) des Anbieters zugreift,
- wobei zunächst ein Bremstyp und/oder die Anzahl an Achsaggregaten (8a, 8b) der Fahrwerksanordnung (9) vom Kunden bestimmt werden,
- wobei in Abhängigkeit des Bremstyps und/oder der Anzahl an Achsaggregaten (8a, 8b) eine Auswahl an weiteren Konfigurationsmerkmalen der Fahrwerksanordnung (9) im Konfigurationsfenster (2) beschränkt wird,
- wobei ferner in Abhängigkeit des Bremstyps und/oder der Anzahl an Achsaggregaten (8a, 8b) zunächst zumindest ein Achskörper (7a) der soweit konfigurierten Fahrwerksanordnung (9) im Visualisierungsfenster (3) als dreidimensionales Modell dargestellt wird, wobei das dreidimensionale Modell im Visualisierungsfenster (3) zumindest verschwenkbar ist,
- wobei jede die im Visualisierungsfenster (3) dargestellte Fahrwerksanordnung (9) beeinflussende Konfiguration im Konfigurationsfenster (2) den zumindest einen Achskörper (7a) um mindestens ein weiteres daran angeordnetes Modul (7) verändert.

## Beschreibung

Die Erfindung betrifft ein computerimplementiertes Verfahren zur datenbankgestützten Konfiguration und Visualisierung einer Fahrwerksanordnung für ein Nutzfahrzeug, wobei auf einer von einem Anbieter für einen Kunden freigeschalteten Nutzeroberfläche ein Konfigurationsfenster und ein Visualisierungsfenster dargestellt werden, und wobei der Kunde über einen Computer auf eine Datenbank des Anbieters zugreift.

Nutzfahrzeuge, insbesondere Nutzfahrzeuganhänger und sogenannte Sattelauflieger sind in der Regel modulartig aufgebaut und an ein darauf aufgenommenes Chassis angepasst. Die Fahrwerksanordnung des Nutzfahrzeugs umfasst zumindest ein Achsaggregat, wobei das zumindest eine Achsaggregat aus mehreren Modulen zusammengesetzt ist. Insbesondere ist das Achsaggregat aus der eigentlichen Radachse mit den Fahrzeugrädern, den Bremsen, den Elementen der Fahrzeugfederung und den Stoßdämpfern zusammensetzt. Bei der Herstellung einer Fahrwerksanordnung für einen Nutzfahrzeug-Sattelauflieger, werden beispielsweise drei Achsaggregate an dem Fahrzeugrahmen des Nutzfahrzeug-Sattelaufliegers befestigt, was zumeist durch Verschrauben oder teils auch durch Verschweißen erfolgt.

Aus der DE 102 17 269 A1 geht ein Verfahren zum elektronischen Konfigurieren von Fahrzeugen durch Kunden mit individuellen Konditionen hervor. Auf dezentralen Terminaleinheiten vom Kunden sind ein oder mehrere Fahrzeuge nach seinen Anforderungen und/oder seinen individuellen Konditionen durch Abruf von in einer zentralen elektronischen Einrichtung des Verkäufers gespeicherten Daten elektronisch konfigurierbar.

Der Erfindung liegt die **Aufgabe** zugrunde, ein computerimplementiertes Verfahren zur datenbankgestützten Konfiguration und Visualisierung einer Fahrwerksanordnung zu schaffen, wobei das Verfahren besonders ergonomisch sein soll.

Zur **Lösung** wird ein computerimplementiertes Verfahren mit den Merkmalen des Patentanspruchs 1 vorgeschlagen. Weitere vorteilhafte Ausführungsformen sind den abhängigen Ansprüchen zu entnehmen.

Gemäß dem erfindungsgemäßen computerimplementierten Verfahren zur datenbankgestützten Konfiguration und Visualisierung einer Fahrwerksanordnung mit mindestens einem aus mehreren Modulen aufgebauten Achsaggregat werden auf einer von einem Anbieter für einen Kunden freigeschalteten Nutzeroberfläche ein Konfigurationsfenster und ein Visualisierungsfenster dargestellt, wobei der Kunde über einen Computer auf eine Datenbank des Anbieters zugreift. Die Nutzeroberfläche wird dem Kunden vorzugsweise auf einem Bildschirm angezeigt. Bevorzugt sind das Konfigurationsfenster und das Visualisierungsfenster nebeneinander oder übereinander angeordnet, wobei der Kunde beide Fenster auf der Nutzeroberfläche gleichzeitig sieht.

In einem ersten Verfahrensschritt werden vom Kunden zunächst ein Bremstyp und/oder die Anzahl an Achsaggregaten der Fahrwerksanordnung bestimmt. Denkbar ist, dass zunächst der Bremstyp und dann die Anzahl an Achsaggregaten bestimmt werden oder zunächst die Anzahl an Achsaggregaten und danach der Bremstyp bestimmt werden. Ebenso ist es denkbar den Bremstyp und die Anzahl an Achsaggregaten gleichzeitig zu bestimmen. Alternativ kann auch nur der Bremstyp oder nur die Anzahl an Achsaggregaten bestimmt werden.

Vorzugsweise kann der Kunde bei der Auswahl des Bremstyps bzw. der Bremsenart zwischen einer Scheibenbremse und einer Trommelbremse wählen, wobei die jeweilige Bremse auch als HD-Bremse bzw. Schwerlastbremse für Schwerlastanwendungen (HD=heavy duty) konfigurierbar ist. Insbesondere wird die Anzahl der Achsaggregate über eine Anzahl von Achslinien angegeben. Beispielsweise entspricht die Auswahl von drei Achslinien einer Fahrwerksanordnung bzw. Fahrwerksausführung mit drei Achsaggregaten. Bevorzugt kann der Kunde bis zu fünf Achsaggregate gleichzeitig konfigurieren.

In Abhängigkeit des Bremstyps und/oder der Anzahl an Achsaggregaten wird eine Auswahl an weiteren Konfigurationsmerkmalen der Fahrwerksanordnung im Konfigurationsfenster auf nur noch mögliche Konfigurationen beschränkt. Durch diese Beschränkung bzw. Eingrenzung der Auswahl an weiteren Konfigurationsmerkmalen erfolgt nicht nur eine Optimierung der notwendigen Rechenoperationen auf der Datenbank, sondern auch eine Optimierung der Datenübertragungsleistung zwischen Datenbank und Computer. Ferner wird auch die Ergonomie für den Kunden bei der Konfiguration der Fahrwerksanordnung gesteigert, weil die durch die Eingrenzung der Auswahl an weiteren Konfigurationsmerkmalen nicht mehr verfügbaren bzw. nicht mehr möglichen Konfigurationsmerkmale eine schnelle und zieloptimierte Konfiguration erlauben.

Ferner wird in Abhängigkeit des Bremstyps und/oder der Anzahl an Achsaggregaten zunächst zumindest ein Achskörper der soweit konfigurierten Fahrwerksanordnung im Visualisierungsfenster als dreidimensionales Modell dargestellt, wobei das dreidimensionale Modell im Visualisierungsfenster zumindest verschwenkbar ist. Das dreidimensionale Modell ist eine perspektivisch verschwenkbare Grafik, die in einem virtuellen Raum mit drei Raumachsen angezeigt wird. Das Verschwenken des dreidimensionalen Modells erfolgt vorzugsweise durch Auswahl einer ersten dafür vorgesehenen virtuellen Taste auf der Nutzeroberfläche oder durch Betätigung eines ersten Bedienelements an einem Peripheriegerät des Computers und ermöglicht eine Drehung des dreidimensionalen Modells um eine Drehachse im virtuellen Raum. Unter einem Peripheriegerät ist beispielsweise eine Tastatur oder Maus zu verstehen.

Vorzugsweise ist das dreidimensionale Modell im Visualisierungsfenster auch verschiebbar und zoombar. Das Verschieben des dreidimensionalen Modells erfolgt vorzugsweise durch Auswahl einer zweiten dafür vorgesehenen virtuellen Taste auf der Nutzeroberfläche oder durch Betätigung eines zweiten Bedienelements an einem Peripheriegerät des Computers und ermöglicht eine Verlagerung des dreidimensionalen Modells in einer zweidimensionalen Ebene. Die Zoomfunktion erfolgt durch Auswahl einer dritten dafür vorgesehenen virtuellen Taste auf der Nutzeroberfläche oder durch Betätigung eines dritten Bedienelements an einem Peripheriegerät des Computers und ermöglicht eine Vergrößerung des dreidimensionalen Modells, die keine Qualitätseinbußen aufweist. Mithin erfolgt keine Vergrößerung von Pixeln, sondern eine reale Vergrößerung im virtuellen Raum. Die Vergrößerung ist somit als reales Zoom zu verstehen und entspricht dem optischen Zoom einer Kamera und somit nicht dem digitalen Zoom, der lediglich einen vorhandenen Bildausschnitt der Kamera vergrößert und dadurch keine weiteren Bildinformationen liefert.

Vorzugsweise wird bei der Visualisierung der Fahrwerksanordnung als Orientierungshilfe im Raum ein nicht zur Konfiguration gehörendes Objekt, beispielsweise eine Fahrbahn bzw. Straße im Visualisierungsfenster angezeigt. Die Straße wird fest positioniert zur Fahrwerksanordnung dargestellt und kann nicht relativ zur Fahrwerksanordnung verlagert werden.

Erfindungsgemäß verändert jede die im Visualisierungsfenster dargestellte Fahrwerksanordnung beeinflussende Konfiguration im Konfigurationsfenster den zumindest einen Achskörper um ein weiteres daran angeordnetes Modul. Vorzugsweise wird das Visualisierungsfenster simultan zum Konfigurationsfenster dargestellt. Mit anderen Worten laufen die Vorgänge im Visualisierungsfenster parallel zu den Vorgängen im Konfigurationsfenster ab. Durch Auswahl eines das dreidimensionale Modell im Visualisierungsfenster verändernden Konfigurationsmerkmals im Konfigurationsfenster wird das dreidimensionale Modell unverzüglich bzw. direkt neu berechnet und im Visualisierungsfenster dargestellt. Dabei wird der Achskörper um die ausgewählten Module ergänzt bzw. durch die Veränderung schon vorhandener Module verändert, wobei die Module korrekt platziert und ordnungsgemäß verbunden am Achskörper dargestellt werden, sodass keine graphischen Überschneidungen im Visualisierungsfenster angezeigt werden. Mithin werden die Module hinsichtlich ihrer räumlichen Lage zueinander exakt positioniert, wobei der Achskörper als Ausgangsmodul vorgesehen ist, an dem sich alle anderen Module ausrichten. Damit sich eine im Konfigurationsfenster getroffene Auswahl auch auf das Visualisierungsfenster auswirkt, muss das jeweilige Modul vollständig bewertet sein, d.h. die für die Visualisierung und Anbindung an der soweit konfigurierten Fahrwerksanordnung notwendigen Angaben enthalten. Für manche Module sind beispielsweise mehrere Angaben notwendig um visualisiert werden zu können. Demgegenüber können über die Auswahl einer einzigen Angabe auch mehrere Module dargestellt werden.

Ferner ist es auch denkbar, dass die vorgenommene Konfiguration zeitlich verzögert im Visualisierungsfenster angezeigt wird. Beispielsweise wird auf der Nutzeroberfläche eine Aktualisierungsfunktion bereitgestellt, die dazu vorgesehen ist, bei Betätigung eine Aktualisierung des Visualisierungsfensters vorzunehmen, sodass alle bislang im Konfigurationsfenster ausgewählten Konfigurationsmerkmale im Visualisierungsfenster angezeigt werden. Die Aktualisierungsfunktion kann nach jeder Auswahl eines Konfigurationsmerkmals oder nach Auswahl mehrerer Konfigurationsmerkmale oder erst abschließend bei Fertigstellung der Fahrwerksanordnung betätigt werden.

Vorzugsweise wird bei Erreichen einer Mindestanzahl von Konfigurationsmerkmalen eine Speicher- und/oder Bestellfunktion auf der Nutzeroberfläche bereitgestellt. Unter einer Mindestanzahl von Konfigurationsmerkmalen ist zu verstehen, dass die Fahrwerksanordnung die soweit notwendigen Konfigurationsmerkmale enthält, um gefertigt werden zu können. Eine Fahrwerksanordnung die eine Mindestanzahl von Konfigurationsmerkmalen enthält kann für eine mittelbare oder unmittelbare Bestellung gespeichert werden. Ferner kann die Bestellung auch unmittelbar ohne eine vorheriges Abspeichern vorgenommen werden. Insbesondere wird die Speicher- und/oder Bestellfunktion auf der Nutzeroberfläche freigeschaltet. Unter der Freischaltung der Speicher- und/oder Bestellfunktion ist zu verstehen, dass die Speicher- und/oder Bestellfunktion auf der Nutzeroberfläche zwar angezeigt aber nicht auswählbar war oder erst zum Zeitpunkt der Auswahl der Mindestanzahl von Konfigurationsmerkmalen auf der Nutzeroberfläche eingeblendet wird. Vorteilhafterweise wird bei Erreichen der Mindestanzahl von Konfigurationsmerkmalen ein Hinweis zur möglichen Speicher- und/oder Bestellfunktion auf der Nutzeroberfläche bereitgestellt. Dieser Hinweis kann graphische und/oder farbige Elemente umfassen, die dem Kunden das Erreichen der Mindestanzahl von Konfigurationsmerkmalen anzeigt.

Die Fahrwerksanordnung kann bis zu fünf Achsaggregate aufweisen. Jedes Achsaggregat wird im zusammengebauten Zustand mit allen seinen Modulen dargestellt. Insbesondere ist während der gesamten Konfiguration zwischen einer Gesamtansicht der Fahrwerksanordnung und einer Einzelansicht des jeweiligen Achsaggregats wählbar. Vorzugsweise werden nach Abschluss der Konfiguration weitere Bedienelemente auf der Nutzeroberfläche eingeblendet, die das Abspeichern und/oder Bestellen der Fahrwerksanordnung ermöglichen. Insbesondere werden die Bedienelemente graphisch und/oder farbig hervorgehoben, um den Kunden die Bedienung zu erleichtern.

Gemäß einer bevorzugten Ausführungsform der Erfindung ist die Nutzeroberfläche eine webbasierte Oberfläche, wobei der Computer über das Internet mit der Datenbank des Anbieters verbunden wird. Die Datenbank kann alternativ auch in einem lokalen Netzwerk an eine Vielzahl von Computern angebunden sein, sodass die Interaktion zwischen Datenbank und Computer unabhängig von der Internetverbindung bzw. von der Internetgeschwindigkeit ist.

Vorzugsweise wird auf der Nutzeroberfläche eine Visualisierungswechselfunktion bereitgestellt, wobei die Visualisierungswechselfunktion das dreidimensionales Modell von dem Computer auf die Datenbank des Anbieters verlagert, wobei im Visualisierungsfenster von der Datenbank gerendert übermittelte Abbildungen des dreidimensionalen Modells dargestellt werden. Die Visualisierungswechselfunktion ist insbesondere für Computer mit unzureichender Grafikleistung und/oder schlechter Internetverbindung vorteilhaft. Mithin dient die Visualisierungswechselfunktion zur Leistung- und Ressourcenschonung des Computers. Dem Käufer werden durch Betätigung der Visualisierungswechselfunktion im Visualisierungsfenster parallel zu der Auswahl im Konfigurationsfenster die soweit konfigurierte Fahrwerksanordnung als statische, zweidimensionale Abbildung visualisiert. Somit kann diese Abbildung weder gedreht, noch verlagert oder vergrößert werden, jedoch ist die zwischen Datenbank und Computer übermittelte Datenmenge um ein Vielfaches kleiner als die Datenmenge, die bei einem dreidimensionalen Modell übermittelt wird. Sobald für ein Modul alle zur Visualisierung notwendigen Angaben bestimmt sind und das Modul somit vollständig bewertet ist, wird automatisch auf der Datenbank oder einem mit der Datenbank verbundenem System eine gerenderte Abbildung erzeugt, und an den Computer übermittelt, um im Visualisierungsfenster angezeigt zu werden. Dabei erfolgt das Rendern des dreidimensionalen Modells zur Erzeugung der statischen Abbildung in Echtzeit. Es werden keine Abbildungen im Vorfeld erzeugt abgespeichert und abgerufen, sondern jeweils just-in-time. Somit sind insbesondere der Speicherbedarf und die Datenverwaltung auf der Datenbank gering. Auch bei der statischen Abbildung kann zwischen der Darstellung eines einzigen Achsaggregats und der gesamten Fahrwerkanordnung umgeschaltet werden.

Vorteilhafterweise werden kundenseitig mehrere Benutzer verwaltet, wobei ein erster Benutzer die Fahrwerksanordnung vollständig konfiguriert, und wobei ein zweiter Benutzer die durch den ersten Benutzer vollständig konfigurierte Fahrwerksanordnung in den Bestellvorgang implementiert. Somit hat der erste Benutzer die Funktion eines Konstrukteurs, wobei der erste Benutzer das Produkt konfiguriert und seine Konfiguration als Bestellvorlage für den zweiten Benutzer abspeichert. Der zweite Benutzer hat die Funktion eines Einkäufers, wobei der zweite Benutzer die Konfiguration des ersten Benutzers abruft sowie Lieferzustände und kaufmännische Details ergänzt. Insbesondere kann der zweite Benutzer die Anzahl der benötigten Fahrwerksanordnungen bestimmen. Anschließend kann der zweite Benutzer eine Produktanfrage oder Produktbestellung auslösen. Mithin ist eine Aufgabentrennung zwischen dem ersten und zweiten Benutzer vorgesehen. Insbesondere können auch weitere Benutzer vorgesehen werden, deren Funktionen voneinander getrennt sind oder sich zumindest teilweise überschneiden. Jedem Benutzer wird vorzugsweise eine rollenspezifische Nutzeroberfläche angezeigt.

Bevorzugt werden über den zweiten Benutzer andere Konfigurationsmerkmale konfiguriert als über den ersten Benutzer. Beispielsweise wird dem zweiten Benutzer im Konfigurationsfenster ein Lieferzustand der Module angezeigt, wobei der zweite Benutzer auswählen kann, ob und wie die jeweiligen Bauteile des Moduls bzw. des Achsaggregats geliefert werden sollen. Vorzugsweise ist zwischen den Lieferzuständen "montiert", "unmontiert" sowie "ohne" zu wählen. Unter einem Modul das "montiert" ist, ist zu verstehen, dass dieses mit dem Achsaggregat fest verbunden ist. Ein "unmontiertes" Modul wird der Bestellung lose beigefügt. Ferner ist ein Modul, mit der Konfigurationsauswahl "ohne" nicht Bestandteil dieser Bestellung, da beispielsweise noch genügend solcher Module bei dem Kunden vorrätig sind. Vorteilhafterweise wird durch die Konfigurationsauswahl "ohne" für ein Modul im Konfigurationsfenster dieses Modul im Visualisierungsfenster zumindest teilweise transparent und ggf. farbig dargestellt, um dem zweiten Benutzer einen Entfall dieses Moduls zu kennzeichnen. Vorteilhafterweise bleibt die durch den ersten Benutzer festgelegte Konfiguration von der Bestellauswahl des zweiten Benutzers unberührt. Alternativ kann der zweite Benutzer, sofern vom Kunden gewünscht, auf die Konfiguration des ersten Benutzers derart Einfluss nehmen, dass weitere, nicht konfigurierte Module hinzugefügt werden.

Vorzugsweise wird auf der Nutzeroberfläche eine Favoritenfunktion bereitgestellt, wobei die Favoritenfunktion das Abspeichern und Abrufen auch einer unvollständig konfigurierter Fahrwerksanordnung ermöglicht. Mit anderen Worten können mit Hilfe der Favoritenfunktion Vorgabewerte abgespeichert werden, um die Finalisierung zu einem späteren Zeitpunkt durchzuführen. Dadurch können kundenabhängig spezifische Voreinstellungen vorgenommen werden.

Vorteilhafterweise kann auf der Nutzeroberfläche ein Expertenmodus ausgewählt werden, wobei der Expertenmodus die Möglichkeit eröffnet, tiefergehende Details zum jeweiligen Modul anzugeben bzw. einzusehen. Um die Benutzung des Konfigurationsfensters möglichst einfach zu gestalten, ist der Expertenmodus in der Standardansicht ausgeschaltet, wobei die Produktkonfiguration ohne die Auswahl des Expertenmodus vollständig abgeschlossen werden kann.

Gemäß einer die Erfindung weiter verbessernden Maßnahme wird auf der Nutzeroberfläche die Konfiguration über eine Artikelnummer von Modulen des Achsaggregats bereitgestellt, wobei durch Eingabe der Artikelnummer weitere Konfigurationsmerkmale, die der eingegebenen Artikelnummer entsprechen, automatisch aus der Datenbank in die Konfiguration eingebunden werden. Somit kann durch Eingabe einer einzigen Artikelnummer die Auswahl verschiedener Konfigurationsmöglichkeiten entfallen, da diese durch die Artikelnummer vorbestimmt sind. Die Konfiguration über eine Artikelnummer hat ferner den Vorteil, dass kundenseitig lagerhaltige Module in der Konfiguration bevorzugt berücksichtigt werden können. Vorteilhafterweise ist die Konfiguration über eine Artikelnummer in einer Standardansicht ausgeschaltet und kann bei Bedarf aktiviert werden.

Bevorzugt wird auf der Nutzeroberfläche eine Isolierfunktion bereitgestellt, wobei die Isolierfunktion eine von den übrigen Modulen des Achsaggregats isolierte Darstellung eines ausgewählten Moduls des Achsaggregats im Visualisierungsfenster anzeigt. Darüber hinaus können im Visualisierungsfenster Zusatzinformationen zu dem isolierten Modul bzw. Bauteil des Achsaggregats angezeigt werden. Beispielsweise kann die Isolierfunktion auf einen Balg des Achsaggregats angewendet werden, wobei dann der Balg isoliert von dem restlichen Achsaggregat im Visualisierungsfenster dargestellt wird, und wobei optional die Anschlussmaße des Balgs eingeblendet werden.

Ferner bevorzugt wird vor der Auswahl eines Moduls des Achsaggregats im Visualisierungsfenster durch Mouseclick bzw. Mausklick, ein Informationsfenster mit unterschiedlichen Informationen zum Modul mittels Mouseover angezeigt. Unter Mouseover ist zu verstehen, dass lediglich der Mauszeiger auf das Modul geführt wird, jedoch keine Auswahl durch Klicken vorgenommen wird. Beispielsweise wird im Informationsfenster die Bezeichnung des Moduls sowie weitere modulspezifische Merkmale bzw. Eigenschaften eingeblendet. Unter einem Mouseclick ist die Betätigung einer Maustaste durch Klicken zu verstehen.

Ferner ist es denkbar auf der Nutzeroberfläche auch weiterführende Informationen zu den Modulen und/oder dem gesamten Achsaggregat einzublenden. Beispiele dafür sind Einbauanleitungen, Pendeluntersuchungen, Offertzeichnungen sowie Datenblätter. Vorzugsweise können diese weiterführenden Informationen von dem Kunden heruntergeladen werden.

Vorteilhafterweise werden im Konfigurationsfenster durch den Kunden ausgewählte Konfigurationsmerkmale der Fahrwerksanordnung markiert. Mit anderen Worten werden im Konfigurationsfenster die durch den Kunden gesetzten Werte derart gekennzeichnet, dass kundenseitig nachvollziehbar ist welche Konfigurationsmerkmale manuell bestimmt wurden und welche automatisch durch das System aufgrund der kundenseitigen Auswahl getroffen wurden. Beispielsweise wird eine durch den Kunden vorgenommenen Auswahl durch einen Punkt neben der Auswahl dargestellt. Sobald eine Modulbaugruppe vollständig konfiguriert ist, wird dem Kunden dies vorzugsweise mit einem Haken neben Modulbaugruppe dargestellt. Eine Modulbaugruppe kann mehrere Module umfassen, wobei ein Modul mehrere Elemente aufweist und mehrere Konfigurationsmöglichkeiten umfassen kann.

Insbesondere werden die Konfigurationsmerkmale der Fahrwerksanordnung im Konfigurationsfenster sortiert in mehrere Dropdown-Listen dargestellt. Die Dropdown-Liste ist ein Steuerelement im Konfigurationsfenster, das die Auswahl eines Wertes aus einer vorgegebenen Liste von Werten ermöglicht. Beispielsweise wird dabei ein schreibgeschütztes Textfeld mit einer der Höhe des Textfeldes angepassten Schaltfläche angezeigt. Vorteilhafterweise wird ein scrollen der Dropdownliste mittels Mausrad ermöglicht. Durch Auswahl der Dropdown-Liste, klappt die Dropdown-Liste mit Werten nach unten oder oben auf und ermöglicht durch eine Selektierung eines der darin befindlichen Werte.

Vorzugsweise wird auf der Nutzeroberfläche ferner ein Hinweisfenster dargestellt, wobei das Hinweisfenster den Kunden durch die Konfiguration der Fahrwerksanordnung leitet. Insbesondere werden im Hinweisfenster Informationen zu der vorgenommenen Konfiguration und/oder zu den noch bevorstehenden Konfigurationsmerkmalen eingeblendet, wobei diese graphisch oder farbig hervorgehoben werden können. Des Weiteren bevorzugt werden zur Steigerung der Ergonomie ausgewählte Elemente bzw. virtuelle Taste auf der Nutzeroberfläche nur zu bestimmten Zeitpunkten angezeigt. Beispielsweise wird ein Warenkorbsymbol zum Einbinden der abgeschlossenen Konfiguration in einen nachgelagerten Bestellvorgang erst nach Bestimmen aller Konfigurationsmöglichkeiten der Fahrwerksanordnung eingeblendet. Ferner kann ein zusätzlicher visueller Effekt dadurch erzielt werden, dass diese Elemente bzw. virtuelle Tasten farbig oder graphisch hervorgehoben werden.

Bevorzugt wird auf der Nutzeroberfläche ferner eine Gewichtsanzeige dargestellt, wobei die Gewichtsanzeige das Gewicht der im Visualisierungsfenster dargestellten Elemente anzeigt. Mit anderen Worten kann in der Gewichtsanzeige zum einen das Gewicht eines einzigen Moduls gemäß einer Isolierfunktion oder das Gewicht eines Achsaggregats oder das Gewicht der gesamten Fahrwerksanordnung angezeigt werden.

Die Erfindung schließt die technische Lehre ein, dass das dreidimensionale Modell aus exakten Konstruktionsdaten gebildet wird. Insbesondere ist das dreidimensionale Modell ein 3D-CAD Modell eines gängigen Formates, dass kundenseitig heruntergeladen und abgespeichert werden kann. Die darin enthaltenen Konstruktionsdaten lassen sich von dem Kunden mit einem geeigneten CAD-Programm anzeigen und weiterverarbeiten. Dies trägt insbesondere zur Benutzerfreundlichkeit des computerimplementierten Verfahrens bei. Aufwendige Umwandlung und Anpassung der Datenformate durch den Kunden entfallen. Das dreidimensionale Modell kann auch aus Grafikformaten, Textformaten oder numerischen Formaten gebildet werden.

Ferner betrifft die Erfindung auch ein Computerprogrammprodukt, enthaltend maschinenlesbare Anweisungen, die, wenn sie auf einem Computer ausgeführt werden, den Computer zu einer Berechnungslogik aufwerten und dazu veranlassen, das erfindungsgemäße Verfahren auszuführen.

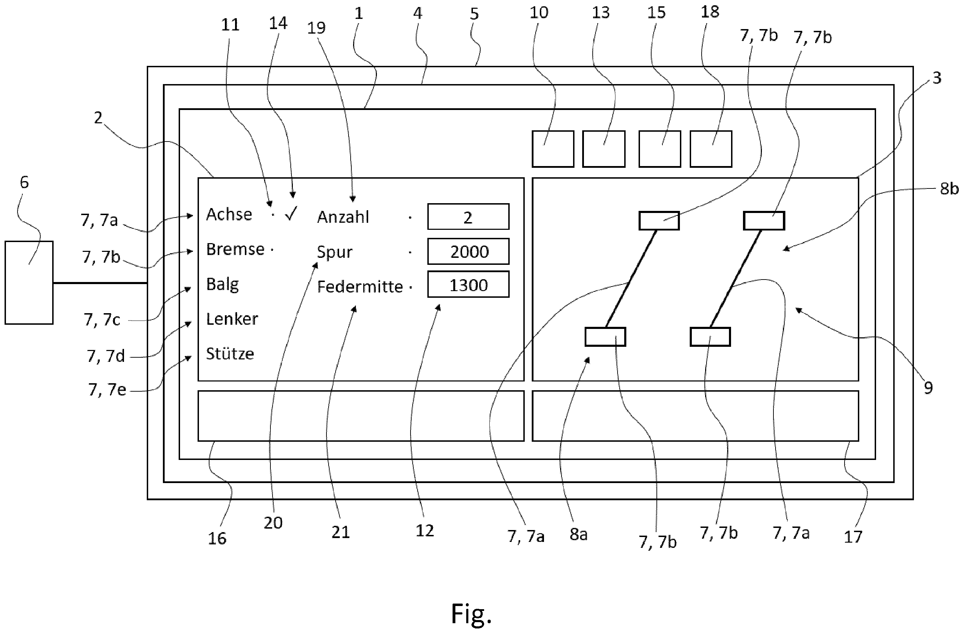

Nachfolgend wird ein Ausführungsbeispiel der Erfindung unter Bezugnahme auf die einzige Figur näher beschrieben. Die einzige Figur zeigen schematisch und beispielhaft eine erfindungsgemäße Nutzeroberfläche, die zur Durchführung des computerimplementierten Verfahrens vorgesehen ist.

Gemäß der einzigen Figur werden auf einer von einem Anbieter für einen Kunden freigeschalteten Nutzeroberfläche 1 ein Konfigurationsfenster 2 und ein Visualisierungsfenster 3 dargestellt. Die Nutzeroberfläche 1 wird vorliegend auf einem Bildschirm 4 eines Computers 5 dargestellt, wobei der Kunde über den Computer 5 auf eine Datenbank 6 des Anbieters zugreift. Die Nutzeroberfläche 1 ist eine webbasierte Oberfläche, wobei der Computer 5 über das Internet mit der Datenbank 6 des Anbieters verbunden ist. Auf dem Computer 5 wird ein Computerprogrammprodukt ausgeführt, das maschinenlesbare Anweisungen enthält, die den Computer zu einer Berechnungslogik aufwerten und dazu veranlassen, ein erfindungsgemäßes computerimplementiertes Verfahren zur datenbankgestützten Konfiguration und Visualisierung einer Fahrwerksanordnung 6 auszuführen. Die Fahrwerksanordnung 9 weist zwei aus jeweils drei Modulen 7, nämlich einem Achskörper 7a und zwei Bremsen 7b, aufgebauten Achsaggregaten 8a, 8b auf. Vorliegend sind die beiden Achsaggregate 8a, 8b identisch zueinander aufgebaut, wobei die Konfiguration noch nicht abgeschlossen ist. Insbesondere müssen weitere Konfigurationsmerkmale wie ein Balg 7c, ein Lenker 7d und eine Stütze 7e im Konfigurationsfenster 2 konfiguriert werden, um dann im Visualisierungsfenster 3 angezeigt zu werden.

Gemäß dem erfindungsgemäßen computerimplementierten Verfahren werden zunächst ein Bremstyp und/oder die Anzahl an Achsaggregaten 8a, 8b der Fahrwerksanordnung 9 vom Kunden bestimmt. In Abhängigkeit des Bremstyps und/oder der Anzahl an Achsaggregaten 8a, 8b wird eine Auswahl an weiteren Konfigurationsmerkmalen der Fahrwerksanordnung 9 im Konfigurationsfenster 2 eingegrenzt. Ferner wird in Abhängigkeit des Bremstyps und/oder der Anzahl an Achsaggregaten 8a, 8b der Achskörper 7a zusammen mit den daran montierten Bremsen 7b der soweit konfigurierten Fahrwerksanordnung 9 im Visualisierungsfenster 3 als dreidimensionales Modell dargestellt. Das dreidimensionale Modell ist im Visualisierungsfenster 3 verschiebbar, verschwenkbar und zoombar angeordnet. Ferner wird das dreidimensionale Modell aus exakten Konstruktionsdaten gebildet. Die Konstruktionsdaten enthalten vorliegend keine Toleranzangaben, sondern genauen Abmaße und Positionsangaben. Das Visualisierungsfenster 3 wird simultan zum Konfigurationsfenster 2 dargestellt, sodass jede die im Visualisierungsfenster 3 dargestellte Fahrwerksanordnung 9 beeinflussende Konfiguration im Konfigurationsfenster 2 den jeweiligen Achskörper 7a mit Bremsen 7b um ein weiteres daran angeordnetes Modul 7 ergänzt. Durch Bestimmen aller Konfigurationsmöglichkeiten im Konfigurationsfenster 2 wird die Konfiguration abgeschlossen und die finalisierte Fahrwerksanordnung 9 im Visualisierungsfenster 3 dargestellt. Dann kann die abgeschlossene Konfiguration für einen nachgelagerten Bestellvorgang abgespeichert oder direkt verwendet werden.

Im Konfigurationsfenster 2 werden durch den Kunden bereits ausgewählte Konfigurationsmerkmale der Fahrwerksanordnung 9 durch Punkte 11 hervorgehoben. Abgeschlossene Konfigurationen innerhalb eines Moduls 7 werden mit einem Haken 14 markiert. Die Konfigurationsmerkmale der Fahrwerksanordnung 9 werden ferner im Konfigurationsfenster 2 sortiert in mehrere Dropdown-Listen 12 dargestellt. Aus der jeweiligen Dropdown-Liste 12 können unterschiedliche Konfigurationsmöglichkeiten ausgewählt werden. Vorliegend werden drei Konfigurationsmöglichkeiten für die Achse 7a im Konfigurationsfenster 2 dargestellt, nämlich eine Anzahl 19, eine Spur 20 sowie eine Federmitte 21, die durch den Kunden manuell konfiguriert wurden. Durch Auswahl der Bremse 7b im Konfigurationsfenster 2 werden gleichzeitig Konfigurationsmöglichkeiten hinsichtlich Anzahl 19, Spur 20 sowie Federmitte 21 der Fahrwerksanordnung 9 ausgeblendet und andere Konfigurationsmöglichkeiten, die für die Bremse 7b geeignet sind, im Konfigurationsfenster 2 eingeblendet.

Auf der Nutzeroberfläche 1 wird eine Visualisierungswechselfunktion 10 bereitgestellt, wobei die Visualisierungswechselfunktion 10 das dreidimensionales Modell von dem Computer 5 auf die Datenbank 6 des Anbieters verlagert, um dann bei jeder Konfigurationsänderung von der Datenbank 6 gerendert übermittelte Abbildungen des dreidimensionalen Modells im Visualisierungsfenster 3 darzustellen. Diese Abbildungen sind statisch und somit nicht verschiebbar, verschwenkbar und zoombar. Mittels der Visualisierungswechselfunktion 10 kann jederzeit zwischen dem dreidimensionalen Modell und der statischen Abbildung gewechselt werden.

Ferner wird auf der Nutzeroberfläche 1 eine Isolierfunktion 13 bereitgestellt, wobei die Isolierfunktion 13 eine von den übrigen Modulen 7 des jeweiligen Achsaggregats 8a, 8b isolierte Darstellung eines ausgewählten Moduls 7 des jeweiligen Achsaggregats 8a, 8b im Visualisierungsfenster 3 anzeigt. Vor der Auswahl zur Isolierung eines Moduls 7 des jeweiligen Achsaggregats 8a, 8b im Visualisierungsfenster 3 durch Mouseclick, wird ein Informationsfenster mit unterschiedlichen Informationen zum jeweiligen Modul 7 mittels Mouseover angezeigt.

Des Weiteren wird auf der Nutzeroberfläche 1 eine Gewichtsanzeige 15 dargestellt, wobei die Gewichtsanzeige 15 das Gewicht der im Visualisierungsfenster 3 dargestellten Elemente anzeigt. Vorliegend würde die Gewichtsanzeige 15 das Gewicht der gesamten soweit konfigurierten Fahrwerksanordnung 9 anzeigen.

Ferner wird auf der Nutzeroberfläche 1 die Konfiguration über eine Artikelnummer von Modulen 7 des jeweiligen Achsaggregats 8a, 8b bereitgestellt. Durch Eingabe der Artikelnummer in ein dafür vorgesehenes Feld 16 auf der Nutzeroberfläche 1 werden automatisch weitere Konfigurationsmerkmale, die der eingegebenen Artikelnummer entsprechen, aus der Datenbank 6 in die Konfiguration der Fahrwerksanordnung 9 eingebunden.

Auch ein Hinweisfenster 17 wird auf der Nutzeroberfläche 1 dargestellt, wobei das Hinweisfenster 17 dazu vorgesehen ist, den Kunden mittels Informationen und Bedienhinweisen durch die Konfiguration der Fahrwerksanordnung 9 zu leiten.

Ferner wird auf der Nutzeroberfläche 1 eine Favoritenfunktion 18 bereitgestellt, wobei die Favoritenfunktion 18 das Abspeichern und Abrufen auch einer unvollständig konfigurierter Fahrwerksanordnung 9 ermöglicht.

Bei diesem Ausführungsbeispiel werden kundenseitig zwei Benutzer verwaltet. Mittels eines ersten Benutzers, dessen Nutzeroberfläche 1 vorliegend dargestellt ist, wird die Fahrwerksanordnung vollständig konfiguriert. Mittels eines zweiten Benutzers, dessen Nutzeroberfläche vorliegend nicht dargestellt ist, wird die durch den ersten Benutzer vollständig konfigurierte Fahrwerksanordnung in den Bestellvorgang implementiert. Über den zweiten Benutzer werden andere Konfigurationsmerkmale konfiguriert als über den ersten Benutzer. Im Rahmen des Bestellvorgangs wird die Bestellung dahingehend finalisiert, dass der Montagezustand der jeweiligen Achsaggregate 8a, 8b und die Anzahl der Fahrwerksanordnungen 9 bestimmt wird. Insbesondere kann der zweite Benutzer jeweilige Module 7 aus der Konfiguration der jeweiligen Achsaggregate 8a, 8b entfernen.

### Bezugszeichenliste

- 1: Nutzeroberfläche
- 2: Konfigurationsfenster
- 3: Visualisierungsfenster
- 4: Bildschirm
- 5: Computer
- 6: Datenbank
- 7: Modul
- 7a: Achskörper
- 7b: Bremse
- 7c: Balg
- 7d: Lenker
- 7e: Stütze
- 8a, 8b: Achsaggregat
- 9: Fahrwerksanordnung
- 10: Visualisierungswechselfunktion
- 11: Punkt
- 12: Dropdown-Liste
- 13: Isolierfunktion
- 14: Haken
- 15: Gewichtsanzeige
- 16: Feld für Artikelnummer
- 17: Hinweisfenster
- 18: Favoritenfunktion
- 19: Anzahl
- 20: Spur
- 21: Federmitte

## Patentansprüche

1. Computerimplementiertes Verfahren zur datenbankgestützten Konfiguration und Visualisierung einer Fahrwerksanordnung (9) mit mindestens einem aus mehreren Modulen (7) aufgebauten Achsaggregat (8a, 8b), wobei auf einer von einem Anbieter für einen Kunden freigeschalteten Nutzeroberfläche (1) ein Konfigurationsfenster (2) und ein Visualisierungsfenster (3) dargestellt werden, und wobei der Kunde über einen Computer (5) auf eine Datenbank (6) des Anbieters zugreift,
- wobei zunächst ein Bremstyp und/oder die Anzahl an Achsaggregaten (8a, 8b) der Fahrwerksanordnung (9) vom Kunden bestimmt werden,
- wobei in Abhängigkeit des Bremstyps und/oder der Anzahl an Achsaggregaten (8a, 8b) eine Auswahl an weiteren Konfigurationsmerkmalen der Fahrwerksanordnung (9) im Konfigurationsfenster (2) beschränkt wird,
- wobei ferner in Abhängigkeit des Bremstyps und/oder der Anzahl an Achsaggregaten (8a, 8b) zunächst zumindest ein Achskörper (7a) der soweit konfigurierten Fahrwerksanordnung (9) im Visualisierungsfenster (3) als dreidimensionales Modell dargestellt wird, wobei das dreidimensionale Modell im Visualisierungsfenster (3) zumindest verschwenkbar ist,
- wobei jede die im Visualisierungsfenster (3) dargestellte Fahrwerksanordnung (9) beeinflussende Konfiguration im Konfigurationsfenster (2) den zumindest einen Achskörper (7a) um mindestens ein weiteres daran angeordnetes Modul (7) verändert.

2. Verfahren nach Anspruch 1, **dadurch gekennzeichnet, dass** die Nutzeroberfläche (1) eine webbasierte Oberfläche ist, wobei der Computer (5) über das Internet mit der Datenbank (6) des Anbieters verbunden wird.

3. Verfahren nach einem der vorangehenden Ansprüche, **dadurch gekennzeichnet, dass** auf der Nutzeroberfläche (1) eine Visualisierungswechselfunktion (10) bereitgestellt wird, wobei die Visualisierungswechselfunktion (10) das dreidimensionales Modell von dem Computer (5) auf die Datenbank (6) des Anbieters verlagert, wobei im Visualisierungsfenster (3) von der Datenbank (6) gerendert übermittelte Abbildungen des dreidimensionalen Modells dargestellt werden.

4. Verfahren nach einem der vorangehenden Ansprüche, **dadurch gekennzeichnet, dass** kundenseitig mehrere Benutzer verwaltet werden, wobei ein erster Benutzer die Fahrwerksanordnung (9) vollständig konfiguriert, und wobei ein zweiter Benutzer die durch den ersten Benutzer vollständig konfigurierte Fahrwerksanordnung (9) in einen Bestellvorgang implementiert.

5. Verfahren nach Anspruch 4, **dadurch gekennzeichnet, dass** über den zweiten Benutzer andere Konfigurationsmerkmale konfiguriert werden als über den ersten Benutzer.

6. Verfahren nach einem der vorangehenden Ansprüche, **dadurch gekennzeichnet, dass** auf der Nutzeroberfläche (1) eine Favoritenfunktion (18) bereitgestellt wird, wobei die Favoritenfunktion (18) das Abspeichern und Abrufen auch einer unvollständig konfigurierten Fahrwerksanordnung (9) ermöglicht.

7. Verfahren nach einem der vorangehenden Ansprüche, **dadurch gekennzeichnet, dass** auf der Nutzeroberfläche (1) die Konfiguration über eine Artikelnummer von Modulen (7) des Achsaggregats (9) bereitgestellt wird, wobei durch Eingabe der Artikelnummer weitere Konfigurationsmerkmale, die der eingegebenen Artikelnummer entsprechen, automatisch aus der Datenbank (6) in die Konfiguration eingebunden werden.

8. Verfahren nach einem der vorangehenden Ansprüche, **dadurch gekennzeichnet, dass** auf der Nutzeroberfläche (1) eine Isolierfunktion (13) bereitgestellt wird, wobei die Isolierfunktion (13) eine von den übrigen Modulen des Achsaggregats (9) isolierte Darstellung eines ausgewählten Moduls (7) des Achsaggregats (9) im Visualisierungsfenster (3) anzeigt.

9. Verfahren nach einem der vorangehenden Ansprüche, **dadurch gekennzeichnet, dass** mittels Mouseover ein Informationsfenster mit unterschiedlichen Informationen zum jeweiligen Modul (7) angezeigt wird.

10. Verfahren nach einem der vorangehenden Ansprüche, **dadurch gekennzeichnet, dass** im Konfigurationsfenster (1) durch den Kunden ausgewählte Konfigurationsmerkmale der Fahrwerksanordnung (9) markiert werden.

11. Verfahren nach einem der vorangehenden Ansprüche, **dadurch gekennzeichnet, dass** die Konfigurationsmerkmale der Fahrwerksanordnung (9) im Konfigurationsfenster (1) sortiert in mehrere Dropdown-Listen (12) dargestellt werden.

12. Verfahren nach einem der vorangehenden Ansprüche, **dadurch gekennzeichnet, dass** auf der Nutzeroberfläche (1) ferner ein Hinweisfenster (17) dargestellt wird, wobei das Hinweisfenster (17) den Kunden durch die Konfiguration der Fahrwerksanordnung (9) leitet.

13. Verfahren nach einem der vorangehenden Ansprüche, **dadurch gekennzeichnet, dass** auf der Nutzeroberfläche (1) ferner eine Gewichtsanzeige (15) dargestellt wird, wobei die Gewichtsanzeige (15) das Gewicht der im Visualisierungsfenster (3) dargestellten Elemente anzeigt.

14. Verfahren nach einem der vorangehenden Ansprüche, **dadurch gekennzeichnet, dass** das dreidimensionale Modell aus exakten Konstruktionsdaten gebildet wird.

15. Verfahren nach einem der vorangehenden Ansprüche, **dadurch gekennzeichnet, dass** bei Erreichen einer Mindestanzahl von Konfigurationsmerkmalen eine Speicher- und/oder Bestellfunktion auf der Nutzeroberfläche (1) bereitgestellt wird.

16. Computerprogrammprodukt, enthaltend maschinenlesbare Anweisungen, die, wenn sie auf einem Computer (5) ausgeführt werden, den Computer (5) zu einer Berechnungslogik aufwerten und dazu veranlassen, ein Verfahren nach einem der Ansprüche 1 bis 15 auszuführen.
